# EUROPEAN PATENT APPLICATION

(11) **EP 4 739 016 A1**
(43) Date of publication of application: **06.05.2026**
(21) Application number: 24914943.6
(22) Date of filing: 12.10.2024
(51) Int. Cl.: H05K 7/20

(54) **ELECTRONIC DEVICE, VAPOR CHAMBER AND PREPARATION METHOD THEREFOR**

(30) Priority: 02.01.2024 CN 202410009564
(71) Applicant: Huawei Technologies Co., Ltd., Shenzhen, Guangdong 518129 (CN)
(72) Inventor: CHEN, Qiu, Shenzhen, Guangdong 518129 (CN); HUANG, Yu, Shenzhen, Guangdong 518129 (CN); JIN, Linfang, Shenzhen, Guangdong 518129 (CN); LIU, Yonglu, Shenzhen, Guangdong 518129 (CN); LUO, Yang, Shenzhen, Guangdong 518129 (CN)
(74) Representative: Huawei European IPR
(86) International application number: PCT/CN2024/124503
(87) International publication number: WO 2025/145723

(57) **Abstract**

An electronic device, a vapor chamber, and a preparation method therefor are disclosed, and relate to the field of electronic devices, to improve heat dissipation performance of the vapor chamber. A specific solution is as follows: The vapor chamber includes a first metal layer, a second metal layer, and a capillary structure. The first metal layer includes a first body part and a first edge part. The second metal layer includes a second body part and a second edge part. A surface of the first edge part is connected to a surface of the second edge part to form a connection layer. A quantity of crystal grains whose grain sizes are less than or equal to 50 µm at the connection layer accounts for 70% or more. The small crystal grains at the connection layer can prevent impurities that affect a capillary force of the capillary structure in an accommodation cavity from entering the accommodation cavity, so that the vapor chamber has good heat dissipation performance. The vapor chamber may include a metal cover and the connection layer, is mainly formed by metal crystal grains with small grain sizes, and may feature high strength and high stiffness macroscopically; or may include a part of non-metal materials, features high flexibility, and satisfies heat dissipation requirements of different electronic products.

## Description

This application claims priority to Chinese Patent Application No. 202410009564.5, filed with the China National Intellectual Property Administration on January 2, 2024 and entitled "ELECTRONIC DEVICE, VAPOR CHAMBER, AND PREPARATION METHOD THEREFOR", which is incorporated herein by reference in its entirety.

### TECHNICAL FIELD

Embodiments of this application relate to the field of electronic devices, and in particular, to an electronic device, a vapor chamber, and a preparation method therefor.

### BACKGROUND

An electronic device (for example, a mobile phone) generates heat during operating. If the heat is accumulated inside the electronic device for a long time, a temperature of the electronic product increases, affecting user experience and even causing a fault. Currently, a vapor chamber (Vapor Chamber, VC) is used to dissipate heat on the electronic device. The vapor chamber is a vacuum cavity with a capillary structure on an inner wall and injected with a working medium (namely, working medium). Currently, heat dissipation performance of the vapor chamber becomes an important factor affecting heat dissipation performance of the electronic device. Therefore, how to improve the heat dissipation performance of the vapor chamber is an urgent problem to be resolved for the vapor chamber.

### SUMMARY

Embodiments of this application provide an electronic device, a vapor chamber, and a preparation method therefor, to improve heat dissipation performance of the vapor chamber.

To achieve the foregoing objective, the following technical solutions are used in this application.

According to a first aspect, an embodiment of this application provides a vapor chamber. The vapor chamber includes a first cover, a second cover, and a capillary structure. The first cover includes a first metal layer, and the first metal layer includes a first body part and a first edge part disposed around a periphery of the first body part. The second cover includes a second metal layer, and the second metal layer includes a second body part and a second edge part disposed around a periphery of the second body part. A surface of the first edge part is connected to a surface of the second edge part to form a connection layer, and the first body part and the second body part jointly enclose an accommodation cavity. The capillary structure is located in the accommodation cavity and is connected to the first body part. In a direction perpendicular to a thickness direction of the connection layer, a quantity of crystal grains whose grain sizes are less than or equal to 50 µm at the connection layer having a length of at least 5 mm accounts for 70% or more of a total quantity of crystal grains. Therefore, there is an advantage of small crystal grain size at a joint between the first cover and the second cover. The small crystal grain is conducive to uniform stress between the first edge part and the second edge part, so that mechanical properties of the first edge part and the second edge part are good. In addition, a size of a crystal grain in the first edge part is small, so that another crystal grain structure on a side that is of the first metal layer and that is away from the accommodation cavity cannot pass through the first edge part and enter the accommodation cavity, to avoid a case that heat dissipation performance of the vapor chamber deteriorates because a capillary force of the capillary structure in the accommodation cavity is affected by the another crystal grain structure. Similarly, a size of a crystal grain in the second edge part is small, so that another crystal grain structure on a side that is of the second metal layer and that is away from the accommodation cavity cannot affect the capillary force of the capillary structure in the accommodation cavity. A better capillary force of the capillary structure indicates better heat dissipation performance of the vapor chamber, thereby effectively improving the heat dissipation performance of the vapor chamber.

With reference to the first aspect, in some possible implementations, the quantity of crystal grains whose grain sizes are less than or equal to 50 µm at the connection layer accounts for 70% or more of the total quantity of crystal grains. Therefore, there is an advantage of good mechanical property at the entire joint between the first cover and the second cover.

With reference to the first aspect, in some implementations, the quantity of crystal grains whose grain sizes are less than or equal to 50 µm at the connection layer accounts for 90% or more of the total quantity of crystal grains. Therefore, there is an advantage of good mechanical property at the entire joint between the first cover and the second cover.

With reference to the first aspect, in some possible implementations, a material of the first metal layer is a first metal material, the first edge part has a first surface and a second surface that are disposed opposite to each other, the second surface is connected to the surface of the second edge part, and a mass percentage of the first metal material is greater than or equal to 95% at a location that is in the first edge part and that is at a distance greater than or equal to 3 µm from the first surface. Therefore, the first edge part is mainly made of the first metal material, and there are a small quantity of or few other materials other than the first metal material. This avoids a case that a large quantity of other materials other than the first metal material affect connection performance between the first edge part and the second edge part. This alleviates a problem that heat dissipation performance of the vapor chamber deteriorates due to a reaction between the material other than the first metal material and a working medium.

With reference to the first aspect, in some possible implementations, a material of the second metal layer is a second metal material, the second edge part has a third surface and a fourth surface that are disposed opposite to each other, the fourth surface is connected to the surface of the first edge part, and a mass percentage of the second metal material is greater than or equal to 95% at a location that is in the second edge part and that is at a distance greater than or equal to 3 µm from the third surface. Therefore, mechanical performance of the second edge part is good, and this alleviates a problem that heat dissipation performance of the vapor chamber deteriorates due to a large quantity of materials other than the second metal material.

With reference to the first aspect, in some possible implementations, the first cover further includes a support layer, and the support layer is connected to a side that is of the first metal layer and that is away from the second metal layer. Therefore, the support layer may be disposed to increase a thickness of the first cover. Strength and the thickness of the first cover may be adjusted by adjusting mechanical strength and a thickness of the support layer.

With reference to the first aspect, in some possible implementations, the second cover further includes a support layer, and the support layer is connected to a side that is of the second metal layer and that is away from the first metal layer. Therefore, the support layer may be disposed to increase strength of the second cover.

With reference to the first aspect, in some possible implementations, a material of the support layer includes at least one of titanium and an alloy thereof, aluminum and an alloy thereof, magnesium and an alloy thereof, and steel. Therefore, there is a range of material options available for the support layer. In addition, because the quantity of crystal grains whose grain sizes are less than or equal to 50 µm at the connection layer having the length of at least 5 mm accounts for 70% or more of the total quantity of crystal grains, it is difficult for the material of the support layer to pass through the first metal layer and enter the accommodation cavity. In this case, the choice of material of the support layer has little impact on heat dissipation performance of a working medium in the accommodation cavity.

With reference to the first aspect, in some possible implementations, the first cover further includes a polymer layer, and the polymer layer is connected to the side that is of the first metal layer and that is away from the second metal layer. A polymer material has low density, which helps reduce a mass of the first cover, lighten the vapor chamber, and implement flexibility.

With reference to the first aspect, in some possible implementations, the second cover further includes a polymer layer, and the polymer layer is connected to the side that is of the second metal layer and that is away from the first metal layer. The polymer material has low density, which helps reduce a mass of the second cover and lighten the vapor chamber.

With reference to the first aspect, in some possible implementations, the material of the first metal layer includes at least one of copper and an alloy thereof, or aluminum and an alloy thereof.

With reference to the first aspect, in some possible implementations, a thickness of the first metal layer ranges from 5 µm to 80 µm. This is because the quantity of crystal grains whose grain sizes are less than or equal to 50 µm at the connection layer having the length of at least 5 mm accounts for 70% or more of the total quantity of crystal grains. Even if the thickness of the first metal layer is only 5 µm, connection performance of a joint between the first edge part and the second edge part is good, and the first metal layer can well isolate a substance that generates a non-condensable gas from entering the accommodation cavity, so that the vapor chamber has good heat dissipation performance.

With reference to the first aspect, in some possible implementations, the thickness of the first metal layer may range from 5 µm to 10 µm. The thickness of the first metal layer is low, so that a quantity of materials used for the first metal layer can be reduced. In addition, the thickness of the first metal layer is within the range, so that impurities entering the accommodation cavity can still be reduced, to reduce generation of the non-condensable gas in the accommodation cavity.

With reference to the first aspect, in some possible implementations, the vapor chamber further includes a plurality of protrusions that are spaced from each other in the accommodation cavity, and one end of each of the plurality of protrusions is connected to the second body part, and the other end is a free end. In this way, the plurality of protrusions may increase a surface area in the accommodation cavity, and increase a contact area between the working medium and the accommodation cavity, so that the working medium is more easily attached to the accommodation cavity. In addition, the plurality of protrusions may guide the gaseous working medium. In addition, the protrusion further has a flow-guiding function. The working medium attached to a surface of the protrusion may flow along the surface of the protrusion and converge. This helps shorten time of a heat cycle of the working medium and improve heat dissipation performance of the vapor chamber.

With reference to the first aspect, in some possible implementations, the capillary structure is connected to the first body part to form an integrated component. Therefore, a connection between the capillary structure and the first body part is good, and the capillary structure and the first body part are not prone to separation. In a scenario in which the vapor chamber is bent, the first body part and the capillary structure that are integrally formed can effectively reduce friction caused by relative movement between the capillary structure and the first body part during bending of the vapor chamber. If the first body part is bent, the capillary structure and the first body part are not prone to delamination and tearing.

According to a second aspect, an embodiment of this application provides a method for preparing a vapor chamber. The method for preparing the vapor chamber includes: providing a first cover, a second cover, and a capillary structure, where the first cover includes a first metal layer, and the first metal layer includes a first body part and a first edge part disposed around a periphery of the first body part; the second cover includes a second metal layer, and the second metal layer includes a second body part and a second edge part disposed around a periphery of the second body part; and the capillary structure is connected to the first body part; and performing first thermal processing on the first cover, the capillary structure, and the second cover that are sequentially stacked, to connect the first edge part to the second edge part. In the first thermal processing, a temperature ranges from 150°C to 400°C, pressure is greater than or equal to 30 MPa, and time is greater than or equal to 30 min. Because the temperature in the first thermal processing is low, a problem that the first cover and the second cover are deformed and oxidized at a high temperature is effectively alleviated. In addition, because the temperature is low, a first thermal processing process has little impact on hardness and yield strength of the first cover and the second cover. The first metal layer and the second metal layer have small grain growth sizes at 150°C to 400°C, so that sizes of 70% or more of the crystal grains at the connection layer are less than 50 µm. The crystal grains at the connection layer are even and small, and internal stress of the connection layer is low, so that the connection layer is not prone to delamination or cracking.

With reference to the second aspect, in some possible implementations, in the first thermal processing, the pressure ranges from 30 MPa to 200 MPa, and the time ranges from 30 min to 100 min.

With reference to the second aspect, in some possible implementations, before a step of performing the first thermal processing on the first cover, the capillary structure, and the second cover that are sequentially stacked, the method further includes: performing second thermal processing on the first cover and the capillary structure, to connect the capillary structure to the first body part. In the second thermal processing, a temperature ranges from 150°C to 400°C, pressure is greater than or equal to 5 MPa, and time is greater than or equal to 30 min. Because the temperature in the second thermal processing is low, a second thermal processing process has little impact on the capillary structure and the first cover, so that the first cover can maintain good hardness and yield strength after the second thermal processing. In the second thermal processing process, the first cover has a small grain growth size, and an element on a side that is of the first cover and that is away from the capillary structure is not likely to diffuse to a side close to the capillary structure. In the second thermal processing process, a micro-nano structure on the capillary structure is not likely to collapse or deformation, and a good capillary force can still be kept.

With reference to the second aspect, in some possible implementations, the pressure ranges from 5 MPa to 200 MPa, and the time ranges from 30 min to 100 min.

With reference to the second aspect, in some possible implementations, before the step of performing the first thermal processing on the first cover, the capillary structure, and the second cover that are sequentially stacked, the method further includes: stacking the first cover, the capillary structure, and the second cover, and filling nanoparticles between the first edge part and the second edge part. In this way, the nanoparticles help rapidly fuse crystal grains on surfaces of the first edge part and the second edge part in the first processing process. The nanoparticle has a function of serving as a crystal grain nucleus, to help shorten time of nucleation on the surfaces of the first edge part and the second edge part, and shorten formation time of the connection layer.

According to a third aspect, an embodiment of this application provides an electronic device. The electronic device includes a printed circuit board and any vapor chamber provided in the first aspect, and the first cover is connected to the printed circuit board. The vapor chamber has good heat dissipation performance. Therefore, the vapor chamber can cool the printed circuit board, and improve heat dissipation performance of the electronic device.

With reference to the third aspect, in some possible implementations, the electronic device further includes a middle frame; the vapor chamber, the middle frame, and the printed circuit board are sequentially stacked; and a through hole that penetrates the middle frame in a thickness direction of the middle frame is disposed on the middle frame, and the first cover passes through the through hole and is connected to the printed circuit board. This helps reduce a total thickness of the middle frame and the vapor chamber, increase integration of the electronic device, and facilitate miniaturization of the electronic device. In addition, the vapor chamber may be considered as a part of the middle frame, and the vapor chamber provides support strength for supporting structures such as a display, so that the vapor chamber has a plurality of functions.

### BRIEF DESCRIPTION OF DRAWINGS

FIG. 1a is a diagram of a structure of an electronic device;
FIG. 1b is a diagram of structures of a middle frame and a vapor chamber according to an embodiment of this application;
FIG. 2a is a diagram of a structure of a vapor chamber according to an embodiment of this application;
FIG. 2b is a diagram of an exploded structure of a vapor chamber according to an embodiment of this application;
FIG. 3a is a diagram of a structure of a vapor chamber in a related technology;
FIG. 3b is a cross-sectional view of a vapor chamber obtained by using a process at a cross section C-C in FIG. 3a;
FIG. 3c is a cross-sectional view of a vapor chamber obtained by using another process at a cross section C-C in FIG. 3a;
FIG. 3d is a cross-sectional view of a vapor chamber obtained by using still another process at a cross section C-C in FIG. 3a;
FIG. 4a is a cross-sectional view of a first edge part and a second edge part at a legend of 50 µm;
FIG. 4b is a cross-sectional view of a first edge part and a second edge part at a legend of 20 µm;
FIG. 4c is a cross-sectional view of a first edge part and a second edge part at a legend of 1 µm;
FIG. 5a is a cross-sectional view at D-D in FIG. 2a;
FIG. 5b is another cross-sectional view at D-D in FIG. 2a;
FIG. 5c is still another cross-sectional view at D-D in FIG. 2a;
FIG. 5d is yet another cross-sectional view at D-D in FIG. 2a;
FIG. 6a is a diagram of an internal structure of another vapor chamber according to an embodiment of this application;
FIG. 6b is a diagram of an internal structure of still another vapor chamber according to an embodiment of this application;
FIG. 7a is a process flowchart of a vapor chamber according to an embodiment of this application;
FIG. 7b is a diagram of a structure when s2 in FIG. 7a is performed;
FIG. 7c is a diagram of a structure when s3 in FIG. 7a is performed; and
FIG. 7d is a diagram of a structure when s4 in FIG. 7a is performed.

In these figures: 10: electronic device; 11: cover; 12: display; 13: printed circuit board; 14: middle frame; 15: rear housing; 16: side frame; 17: through hole; 171: stepped surface; 100: vapor chamber; 110: first cover; 120: second cover; 130: capillary structure; 111: first metal layer; 101: first body part; 102: first edge part; 112: support layer; 113: polymer layer; 121: second metal layer; 201: second body part; 202: second edge part; 20: connection layer; 140: accommodation cavity; 150: protrusion; 01: vapor chamber; 02: upper cover; 03: lower cover; 04: capillary component; 05: solder layer; 06: flow guide column; 103: first surface; 104: second surface; 122: opening; 203: third surface; and 204: fourth surface.

### DESCRIPTION OF EMBODIMENTS

To make the objectives, technical solutions, and advantages of this application clearer, the following further describes this application in detail with reference to the accompanying drawings.

Terms "first" and "second" mentioned below are merely intended for a purpose of description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more than two.

In addition, in this application, position terms such as "upper" and "lower" are defined relative to an illustrative position of a component in the accompanying drawings. It should be understood that these direction terms are relative concepts and are used for relative description and clarification, and may vary accordingly depending on a position change in which components are placed in the accompanying drawings.

A vapor chamber (vapor chamber, VC) is also referred to as a vapor chamber, and is a vacuum cavity with a fine structure on an inner wall and capable of being injected with a working medium. An operating principle of the vapor chamber specifically includes four main steps: conduction, evaporation, convection, and condensation. When heat generated by a heat source enters the vapor chamber through heat conduction, the working medium that is in the vapor chamber and that is close to a position of the heat source absorbs heat and then is vaporized rapidly while taking away a large amount of heat. Then, with a heat dissipation property of vapor, when vapor in the vapor chamber diffuses from a high-temperature zone to a low-temperature zone and is in contact with an inner wall with a lower temperature, the vapor rapidly condenses into a liquid state and releases thermal energy; and the working medium condensed into the liquid state returns to the heat source through a capillary structure, to complete a heat conduction cycle, and form a bidirectional circulation system in which vapor and liquid coexist in the working medium.

Capillary structure: Because a liquid surface of liquid has surface tension, when the liquid is infiltrated into a capillary hole, the liquid surface of the liquid is concave, so that the liquid surface of the liquid exerts a pull force on the liquid below, causing the liquid to move upward along a wall of the capillary hole. This causes a capillary phenomenon. The capillary structure may include a plurality of capillary holes or a structure like a fine groove similar to a capillary hole. Therefore, after a liquid working medium enters the capillary hole or the fine groove in the capillary structure, the liquid working medium flows to the other end of the capillary hole through a capillary action, to complete transfer and return of the working medium.

This application provides an electronic device. The electronic device may be a terminal device having an antenna and an electrical connector. The electronic device may be implemented in various forms, including but not limited to a mobile phone (mobile phone), a tablet computer (pad), a personal digital assistant (personal digital assistant, PDA), a desktop computer, a wearable device, a display device (for example, a television), an information display device, a smart home terminal, or the like. In addition, in embodiments of this application, the electronic device may be a foldable device, for example, a foldable mobile phone. Alternatively, the electronic device may be a bar phone (bar phone). In embodiments of this application, an example in which the electronic device is a mobile phone is used for description.

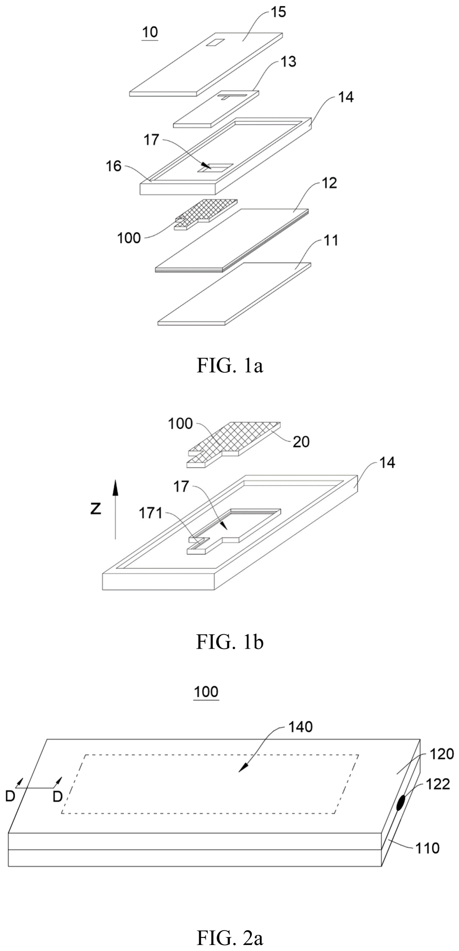

FIG. 1a is a diagram of a structure of an electronic device 10. As shown in FIG. 1a, the electronic device 10 may include a cover (cover) 11, a display (display) 12, a printed circuit board (printed circuit board, PCB) 13, a middle frame (middle frame) 14, and a rear housing 15. In some embodiments, the rear housing 15 is also referred to as a rear cover (rear cover). The cover 11, the display 12, and the rear housing 15 are stacked.

The cover 11 may be disposed close to the display 12, and the cover 11 is configured to protect the display 12 and prevent dust from entering the display 12. The cover 11 may be a glass cover (cover glass), or may be replaced with a cover made of another material, for example, a cover made of an ultra-thin glass material or a cover made of a polyethylene terephthalate (polyethylene terephthalate, PET) material.

The display 12 may include a liquid crystal display (liquid crystal display, LCD) panel, a light-emitting diode (light-emitting diode, LED) display panel, an organic light-emitting semiconductor (organic light-emitting diode, OLED) display panel, or the like. This is not limited in this application. A type of the display 12 includes but is not limited to a water drop screen, a notch screen, a bezel-less screen, or a notched screen.

The middle frame 14 has a function of supporting the entire electronic device. The middle frame 14 includes a high-thermal conductivity material (for example, copper or aluminum), and the middle frame 14 has a high heat conduction rate, to dissipate heat inside the electronic device 10 to the outside of the electronic device 10. The printed circuit board 13 shown in FIG. 1a is disposed between the middle frame 14 and the rear housing 15. It should be understood that, in some embodiments, the printed circuit board 13 may alternatively be disposed between the middle frame 14 and the display 12. This is not limited in embodiments of this application.

For example, the electronic device 10 may further include a battery (not shown in the figure). The battery may be disposed between the middle frame 14 and the rear housing 15, or the battery may be disposed between the middle frame 14 and the display 12. This is not limited in this application.

For example, the printed circuit board 13 carries an electronic component, for example, a radio frequency chip. In some embodiments, components such as an input button, a transmitter, a processor, a memory, a battery, a charging circuit, and a system on chip (system on chip, SoC) structure may be mounted on the printed circuit board 13 or connected to the printed circuit board 13.

In some embodiments, the printed circuit board 13 is divided into a mainboard and a subboard. The battery may be disposed between the mainboard and the subboard. The mainboard may be disposed between the middle frame 14 and an upper edge of the battery, and the subboard may be disposed between the middle frame 14 and a lower edge of the battery.

In some embodiments, the electronic device 10 may further include a side frame 16, and the side frame 16 may be made of a conductive material like metal. The side frame 16 may be disposed between the display 12 and the rear housing 15 and extend circumferentially around a periphery of the display 12. The side frame 16 may have four side edges surrounding the display 12, and the four side edges help fasten the display 12.

In FIG. 1a, the side frame 16 is connected to the middle frame 14 to form an integrated component, and the side frame 16 and the middle frame 14 jointly support the entire electronic device 10. The rear housing 15 and the cover 11 are respectively covered on two opposite sides of the side frame 16 to form an enclosure/housing (housing) of the electronic device. In some other embodiments, the side frame 16 and the middle frame 14 may be connected through a spring, a screw, welding, or the like.

In some embodiments, the electronic device 10 includes a vapor chamber 100, and the vapor chamber 100 may be connected to the electronic component on the printed circuit board 13. When the electronic device 10 operates, the printed circuit board 13 generates a large amount of heat, and the vapor chamber 100 connected to the printed circuit board 13 may dissipate heat for the printed circuit board 13.

A manner of connecting the vapor chamber 100 to the printed circuit board 13 is not limited in embodiments of this application. In some embodiments, the middle frame 14 is located between the printed circuit board 13 and the vapor chamber 100. Heat on the printed circuit board 13 is transferred to the middle frame 14, and then is dissipated by the vapor chamber 100. In some embodiments, a hollow zone is disposed on the middle frame 14, and some components (for example, a chip) on the printed circuit board 13 pass through the hollow zone and are attached to the vapor chamber 100. Alternatively, a part of the vapor chamber 100 passes through the hollow zone and is attached to the printed circuit board 13.

In some embodiments, the vapor chamber 100 may be located between the middle frame 14 and the printed circuit board 13.

It may be understood that, in another embodiment of this application, the vapor chamber 100 may be connected to another structure (for example, the rear housing 15) in the electronic device 10. This is not limited in embodiments of this application.

FIG. 2a is a diagram of a structure of the vapor chamber 100 according to an embodiment of this application. Refer to FIG. 2a. The vapor chamber 100 includes a first cover 110 and a second cover 120. The first cover 110 and the second cover 120 jointly enclose an accommodation cavity 140.

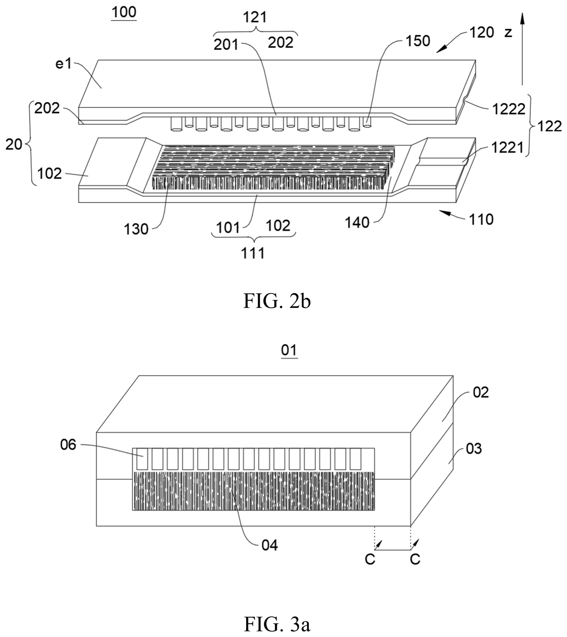

FIG. 2b is a diagram of an exploded structure of the vapor chamber 100 according to this embodiment of this application. Refer to FIG. 2b. The vapor chamber 100 further includes a capillary structure 130. The first cover 110, the capillary structure 130, and the second cover 120 are sequentially stacked. A thickness direction of the vapor chamber 100 is defined as a z direction, and the first cover 110, the capillary structure 130, and the second cover 120 are stacked in the z direction.

The first cover 110 includes a first metal layer 111, the first metal layer 111 includes a first body part 101 and a first edge part 102, the first edge part 102 is disposed around a periphery of the first body part 101, and the first edge part 102 is connected to the first body part 101, for example, the first edge part 102 is connected to the first body part 101 to form an integrated component. The second cover 120 includes a second metal layer 121, the second metal layer 121 includes a second body part 201 and a second edge part 202, the second edge part 202 is disposed around a periphery of the second body part 201, and the second body part 201 is connected to the second edge part 202, for example, the second body part 201 is connected to the second edge part 202 to form an integrated component.

The first metal layer 111 and the second metal layer 121 are stacked in the z direction, and a surface of the first edge part 102 is connected to a surface of the second edge part 202 to form a connection layer 20. In other words, the connection layer 20 includes the first edge part 102 and the second edge part 202 that are connected. The first body part 101 and the second body part 201 jointly enclose the accommodation cavity 140. The capillary structure 130 is located in the accommodation cavity 140 and is connected to the first body part 101. A quantity of crystal grains whose grain sizes are less than or equal to 50 µm (micrometers) at the connection layer 20 having a length of at least 5 mm (millimeters) accounts for 70% or more of a total quantity of crystal grains.

In embodiments of this application, the "edge" in the first edge part 102 is a part that is located on the periphery of the first body part 101 and that is directly connected to or in direct contact with the first body part 101. Similarly, the "edge" in the second edge part 202 is a part that is located on the periphery of the second body part 201 and that is directly connected to or in direct contact with the second body part 201. There is no bubble between the first edge part 102 and the second edge part 202, or a size of a bubble between the first edge part 102 and the second edge part 202 is less than or equal to 10 µm. Widths of the first edge part 102 and the second edge part 202 are not limited in embodiments of this application.

FIG. 3a is a diagram of a structure of a vapor chamber 01 in a related technology. In FIG. 3a, the vapor chamber 01 includes an upper cover 02, a lower cover 03, a flow guide column 06, and a capillary component 04. The upper cover 02 and the lower cover 03 jointly enclose a cavity, and both the capillary component 04 and the flow guide column 06 are located in the cavity. Materials of the upper cover 02 and the lower cover 03 are both copper.

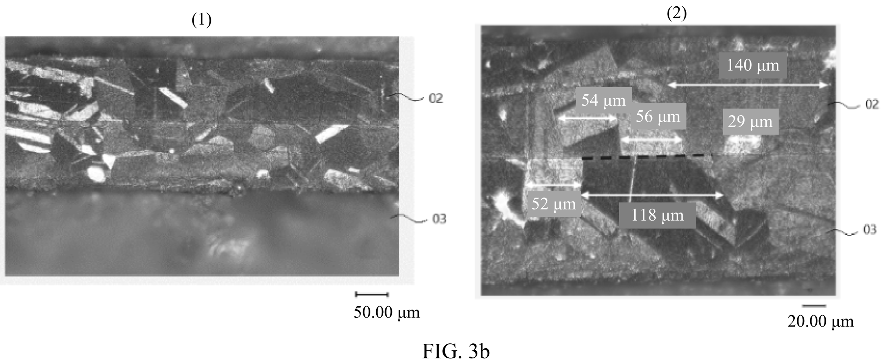

FIG. 3b is a cross-sectional view of a vapor chamber 01 obtained by using a process at a cross section C-C in FIG. 3a. In FIG. 3b, an upper cover 02 is connected to a lower cover 03 through high-temperature diffusion soldering. A soldering temperature ranges from 700°C to 850°C. The temperature of 700°C to 850°C causes a decrease in a capillary force of a capillary component, and causes deformation of the upper cover 02 and the lower cover 03. Consequently, structural strength of the vapor chamber 01 is not high. A legend of (1) in FIG. 3b is 50 µm, and a legend of (2) in FIG. 3b is 20 µm. It can be learned from FIG. 3b that a size of a crystal grain at a joint between the upper cover 02 and the lower cover 03 ranges from 29 µm to 140 µm. The crystal grain is large.

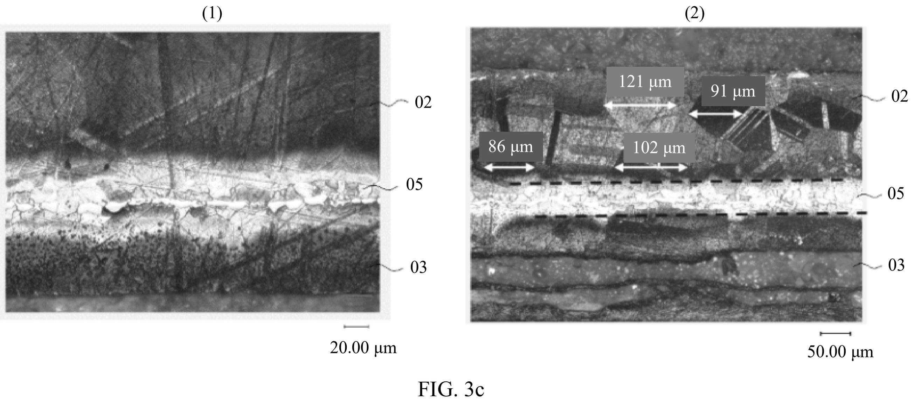

FIG. 3c is a cross-sectional view of a vapor chamber 01 obtained by using another process at a cross section C-C in FIG. 3a. In FIG. 3c, an upper cover 02 and a lower cover 03 are soldered by using solder paste, and a solder layer 05 is formed between the upper cover 02 and the lower cover 03. A legend of (1) in FIG. 3c is 20 µm, and a legend of (2) in FIG. 3c is 50 µm. It can be learned from FIG. 3c that there is a pore at a joint between the upper cover 02 and the lower cover 03, and existence of the pore affects air tightness and a vacuum degree of the vapor chamber 01. Consequently, heat dissipation performance of the vapor chamber 01 deteriorates. In addition, a size of a crystal grain at the joint between the upper cover 02 and the lower cover 03 ranges from 91 µm to 102 µm. The crystal grain is large. In addition, in a process of soldering the upper cover 02 and the lower cover 03, the solder paste enters a cavity, affecting a capillary force of a capillary component. The solder paste is decomposed at a high temperature to generate a non-condensable gas (non-condensable gas, NCG). As a result, a vacuum degree of the cavity is affected and heat dissipation performance of the vapor chamber 01 deteriorates. The solder paste forms the solder layer between the upper cover 02 and the lower cover 03, and the solder layer reduces mechanical strength, yield strength, and the like of the vapor chamber 01.

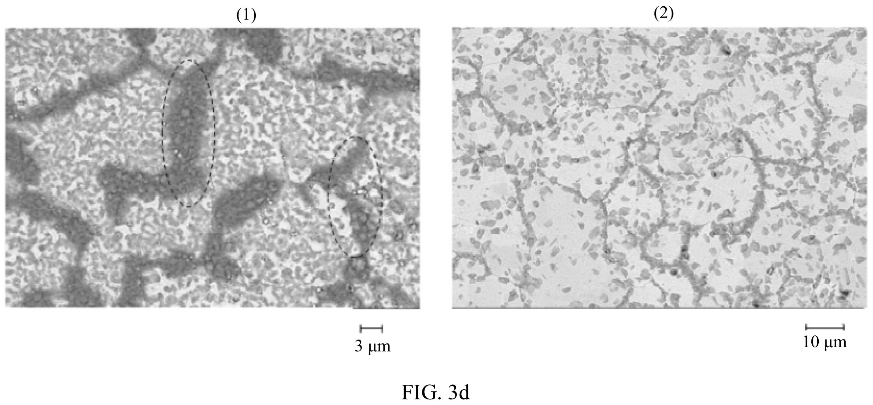

FIG. 3d is a cross-sectional view of a vapor chamber 01 obtained by using still another process at a cross section C-C in FIG. 3a. In FIG. 3d, an upper cover 02 includes a copper layer and a stainless steel layer that are stacked, and a lower cover 03 includes a copper layer and a stainless steel layer that are stacked. A legend of (1) in FIG. 3d is 3 µm, and a legend of (2) in FIG. 3d is 10 µm. In (1) in FIG. 3d, a dark gray part in a dashed-line box is stainless steel, and a light gray part is a copper crystal grain. It can be learned from FIG. 3d that a size of a copper crystal grain at a joint between the upper cover 02 and the lower cover 03 is large, and a part of components (for example, a carbon element or an iron element) in stainless steel is doped between copper crystal grains. The component (for example, an iron crystal grain) in the stainless steel enters a cavity and generates a non-condensable gas with water in the cavity. As a result, a vacuum degree of the cavity is affected and heat dissipation performance of the vapor chamber 01 deteriorates.

In addition, in the related technology, in a process of connecting the upper cover 02 to the lower cover 03, crystal grains in the upper cover 02 and the lower cover 03 grow, and sizes of a part of the crystal grains reach 100 µm. The growth of the crystal grain causes a decrease in strength of the upper cover 02 and the lower cover 03. After the upper cover 02 is connected to the lower cover 03, hardness and yield strength of the upper cover 02 and the lower cover 03 decrease by 40%, which greatly affects mechanical performance of the vapor chamber.

The vapor chamber 100 provided in embodiments of this application has a good heat dissipation capability.

Still refer to FIG. 2b. In this application, the quantity of crystal grains whose grain sizes are less than or equal to 50 µm at the connection layer 20 having the length of at least 5 mm accounts for 70% or more of the total quantity of crystal grains. The length of the connection layer 20 is a size of the connection layer 20 in a direction perpendicular to a thickness direction of the connection layer 20. In other words, in a direction perpendicular to the z direction, the quantity of crystal grains whose grain sizes are less than or equal to 50 µm at the connection layer 20 having the length of at least 5 mm accounts for 70% or more of the total quantity of crystal grains. There are a plurality of directions perpendicular to the z direction. Therefore, a quantity of crystal grains whose grain sizes are less than or equal to 50 µm at the connection layer 20 having the length of at least 5 mm in any direction may account for 70% or more of the total quantity of crystal grains. For example, the quantity of crystal grains whose grain sizes are less than or equal to 50 µm at the connection layer 20 having the length of at least 5 mm accounts for 70%, 75%, 80%, 85%, 90%, 91%, 92%, 93%, 94%, 95%, 96%, 97%, 98%, 99%, or 100% of the total quantity of crystal grains.

The crystal grain (crystal grain) is a tiny or micrometer-scale crystal. The grain size is a line length of the crystal grain or a diameter of the crystal grain, and is the largest size in sizes of the crystal grain in all directions. For example, the grain size may be used to obtain a crystal phase diagram by using an X-ray (X-ray) diffraction pattern, metallography, a scanning electron microscope (scanning electron microscope, SEM), or the like.

There is an advantage of small crystal grain size at the joint between the first cover 110 and the second cover 120. The small crystal grain is conducive to uniform stress between the first edge part 102 and the second edge part 202, so that mechanical properties of the first edge part 102 and the second edge part 202 are good. In addition, a size of a crystal grain in the first edge part 102 is small, so that another crystal grain structure on a side that is of the first metal layer 111 and that is away from the accommodation cavity 140 cannot pass through the first edge part 102 and enter the accommodation cavity 140, to avoid a case that heat dissipation performance of the vapor chamber 100 deteriorates because a capillary force of the capillary structure 130 in the accommodation cavity 140 is affected by the another crystal grain structure. Similarly, a size of a crystal grain in the second edge part 202 is small, so that another crystal grain structure on a side that is of the second metal layer 121 and that is away from the accommodation cavity 140 cannot affect the capillary force of the capillary structure 130 in the accommodation cavity 140. A better capillary force of the capillary structure 130 indicates better heat dissipation performance of the vapor chamber 100, thereby effectively improving the heat dissipation performance of the vapor chamber 100.

In addition, that sizes of crystal grains in the first edge part 102 and the second edge part 202 are small indicates that the first edge part 102 and the second edge part 202 have small grain growth sizes in a process of connecting the first edge part 102 to the second edge part 202. This indicates that a connection process condition of the first edge part 102 and the second edge part 202 may not satisfy a process condition (for example, a high temperature) for a large grain growth size, thereby avoiding a case that the process condition weakens mechanical properties of the first cover 110 and the second cover 120 and reduces the capillary force of the capillary structure 130. For example, the high temperature may cause a micro-nano structure on a surface of the capillary structure 130 to collapse or melt. The micro-nano structure includes micron-level or nano-level pores, barb structures, needle-like protrusions, or the like on the surface of the capillary structure 130.

In some embodiments, the quantity of crystal grains whose grain sizes are less than or equal to 50 µm at the connection layer 20 accounts for 70% or more of the total quantity of crystal grains. In other words, sizes of 70% or more of crystal grains at the entire connection layer 20 are less than or equal to 50 µm. Therefore, there is an advantage of good mechanical property at the entire joint between the first cover 110 and the second cover 120, and the vapor chamber 100 has good heat dissipation performance.

In embodiments of this application, the "metal" in the first metal layer 111 is not limited to a metal element, and may include a metal alloy. The same applies to the "metal" in the second metal layer 121.

For example, a material of the first metal layer 111 includes at least one of copper and an alloy thereof, or aluminum and an alloy thereof. Melting points of the copper and the alloy thereof or the aluminum and the alloy thereof are low, and a temperature requirement is low (for example, 150°C to 400°C) in a process of connecting the first metal layer 111 to the second metal layer 121. It may be understood that the first metal layer 111 may further include an unavoidable impurity, for example, an unavoidable impurity in a process of forming a raw material of the first metal layer 111 at a current technical level.

Similarly, in some embodiments, a material of the second metal layer 121 includes at least one of the copper and the alloy thereof, or the aluminum and the alloy thereof. The following uses an example in which the material of the second metal layer 121 is copper for description. In an embodiment in which both the material of the first metal layer 111 and the material of the second metal layer 121 include copper, because copper has good ductility, after the copper is connected to the copper, the first edge part 102 and the second edge part 202 are more closely connected, and good heat transfer performance of the copper can improve heat conduction performance of the vapor chamber 100.

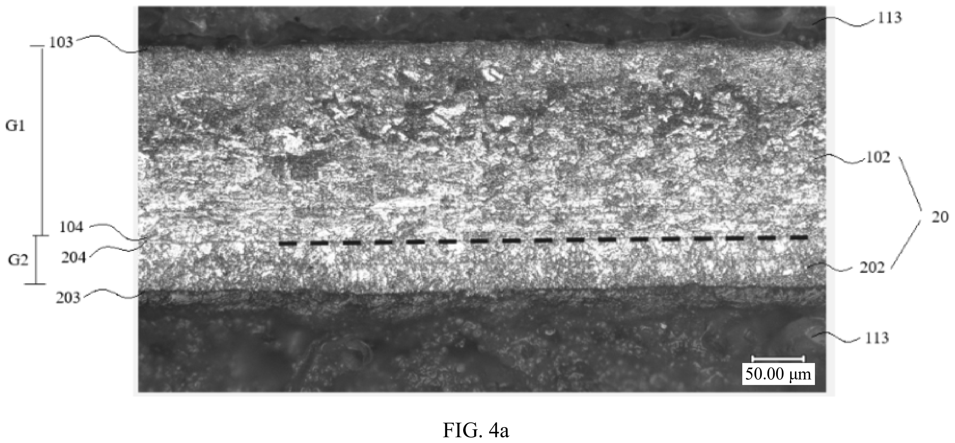

FIG. 4a is a cross-sectional view of the first edge part 102 and the second edge part 202 at a legend of 50 µm. It can be learned from FIG. 4a that crystal phase structures of the first edge part 102 and the second edge part 202 are uniform, and there is almost no bubble or gap at a joint (a dashed line in FIG. 4a) between the first edge part 102 and the second edge part 202.

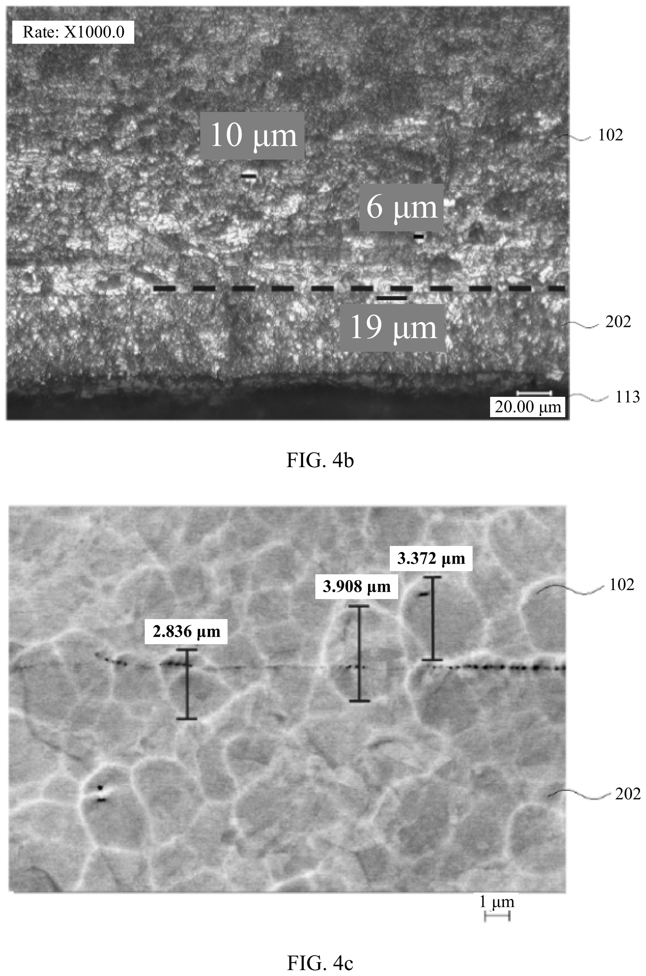

FIG. 4b is a cross-sectional view of the first edge part 102 and the second edge part 202 at a legend of 20 µm. A maximum size of a crystal grain in a cross section in FIG. 4b is 19 µm. FIG. 4c is a cross-sectional view of the first edge part 102 and the second edge part 202 at a legend of 1 µm. A maximum size of a crystal grain in a cross section in FIG. 4c is 4 µm. In addition, there is no pore between the first edge part 102 and the second edge part 202. This indicates that air tightness of the joint between the first edge part 102 and the second edge part 202 is good.

In some embodiments, a quantity of crystal grains whose grain sizes are less than or equal to 50 µm in the first body part 101 accounts for 70% or more of a total quantity of crystal grains. For example, the quantity of crystal grains whose grain sizes are less than or equal to 50 µm in the first body part 101 accounts for 70%, 75%, 80%, 85%, 90%, 91%, 92%, 93%, 94%, 95%, 96%, 97%, 98%, 99%, or 100% of the total quantity of crystal grains. Therefore, the first body part 101 also has a good mechanical property. Similarly, in some embodiments, a quantity of crystal grains whose grain sizes are less than or equal to 50 µm in the second body part 201 accounts for 70% or more of a total quantity of crystal grains. Therefore, the second body part 201 also has a good mechanical property.

In some embodiments, a size of a pore between the first edge part 102 and the second edge part 202 is less than or equal to 2 µm. For example, the size of the pore between the first edge part 102 and the second edge part 202 is 0 µm, 0.001 µm, 0.1 µm, 0.2 µm, 0.3 µm, 0.5 µm, 0.8 µm, 1 µm, 1.1 µm, 1.2 µm, 1.5 µm, 1.8 µm, 2 µm, or the like. There is no pore or a small pore between the first edge part 102 and the second edge part 202, so that air tightness between the first edge part 102 and the second edge part 202 is good. In addition, problems of uneven stress and low structural strength between the first edge part 102 and the second edge part 202 that are caused by the pore can be avoided.

Still refer to FIG. 4a. In an example in FIG. 4a, there are a small proportion of materials other than the material of the first metal layer 111 in the first edge part 102. For example, the material of the first metal layer 111 includes a first metal material. The first edge part 102 includes a first surface 103 and a second surface 104 that are disposed opposite to each other, and the second surface 104 is connected to a surface of the second edge part 202. The first surface 103 is a surface away from the second edge part 202. A mass percentage of the first metal material is greater than or equal to 95% at a location that is in the first edge part 102 and that is at a distance greater than or equal to 3 µm from the first surface 103. In FIG. 4a, a zone G1 is located in the first edge part 102, and a distance between each point in the zone G1 and the first surface 103 is greater than or equal to 3 µm. A mass percentage of the first metal material in the zone G1 is greater than or equal to 95%. For example, the mass percentage of the first metal material in the zone G1 is 95%, 96%, 97%, 98%, 99.0%, 99.2%, 99.5%, 99.8%, 99.9%, 99.99%, 100%, or the like. Therefore, the first edge part 102 is mainly made of the first metal material, and there are a small quantity of or few other materials other than the first metal material. This avoids a case that a large quantity of other materials other than the first metal material affect connection performance between the first edge part 102 and the second edge part 202. This alleviates a problem that heat dissipation performance of the vapor chamber deteriorates due to a reaction between the material other than the first metal material and a working medium.

In an embodiment in which the first metal layer 111 is a copper layer, the first metal material is copper. Sizes of 70% of copper crystal grains in the zone G1 are less than or equal to 50 µm, and a mass percentage of copper in the zone G1 is greater than or equal to 95%. In other words, the copper crystal grains in the zone G1 are fine and even, content of non-copper materials is small, and the non-copper materials have little impact on brittleness of the zone G1, so that mechanical performance of the zone G1 is good.

By analogy, in an embodiment in which the first metal layer 111 is a copper alloy layer, the first metal material is a copper alloy. A mass percentage of the copper alloy in the zone G1 is greater than or equal to 95%. In an embodiment in which the first metal layer 111 is an aluminum alloy layer, the first metal material is an aluminum alloy, and a mass percentage of the aluminum alloy in the zone G1 is greater than or equal to 95%.

Similarly, a material of the second edge part 202 includes a second metal material. The second edge part 202 includes a third surface 203 and a fourth surface 204 that are disposed opposite to each other, and the fourth surface 204 is connected to a surface of the first edge part 102. The third surface 203 is a surface away from the first edge part 102. A mass percentage of the second metal material is greater than or equal to 95% at a location that is in the second edge part 202 and that is at a distance greater than or equal to 3 µm from the third surface 203. In FIG. 4a, a zone G2 is located in the second edge part 202, and a distance between each point in the zone and the third surface 203 is greater than or equal to 3 µm. A mass percentage of the second metal material in the zone G2 is 95%, 96%, 97%, 98%, 99.0%, 99.2%, 99.5%, 99.8%, 99.9%, 99.99%, 100%, or the like. Similar to the first edge part 102, mechanical performance in the zone G2 is good, and this alleviates a problem that heat dissipation performance of the vapor chamber deteriorates due to a large quantity of materials other than the second metal material.

In some embodiments, a mass percentage of a doped material is less than or equal to 5% at a location that is at the connection layer 20 and that is at a distance greater than or equal to 3 µm from the third surface 203 and at a distance greater than or equal to 3 µm from the first surface 103, for example, the mass percentage of the doped material is 5%, 4%, 3%, 2%, 1%, 0.5%, 0.1%, 0.01%, or 0. The doped material is a material other than the second metal material and the first metal material. Therefore, the connection layer 20 does not include solder or the like, so that a non-condensable gas problem shown in FIG. 3c caused by the solder can be avoided.

In some other embodiments, there may be a small quantity of doped materials at a joint between the second surface 104 and the fourth surface 204, and a mass percentage of the doped materials is less than or equal to 10%, for example, may be 10%, 8%, 7%, 5%, 4%, 2%, 1%, 0.5%, 0.1%, or 0.01%. The doped material may be carbon. The doped material may be considered as a nucleus of the first metal material.

For example, a first groove 1221 is disposed on a side that is of the first edge part 102 and that faces the second edge part 202, and a second groove 1222 is disposed on a side that is of the second edge part 202 and that faces the first edge part 102. After the first edge part 102 is connected to the second edge part 202 to form the connection layer 20, the first groove 1221 and the second groove 1222 jointly form an opening 122. The opening 122 communicates with the accommodation cavity 140. The opening 122 may be a liquid injection port or a vacuum port. For example, a working medium may be injected into the accommodation cavity 140 through the opening 122, and the accommodation cavity 140 is vacuumized through the opening 122. Then, the opening 122 is sealed, so that the accommodation cavity 140 is in a vacuum negative pressure state, and the working medium in the accommodation cavity 140 is also in a negative pressure state. The working medium in the negative pressure state is more likely to vaporize after being heated. After the opening 122 is sealed, air tightness of the accommodation cavity 140 is less than or equal to 10⁻⁵ Pa·m³/s, satisfying an air tightness requirement of the vapor chamber 100.

The connection layer 20 may not include the opening 122. A process of sealing the opening 122 is not limited in embodiments of this application. For example, the opening 122 may be sealed through ultrasonic soldering. It may be understood that, in another embodiment, the opening 122 may be disposed at another position of the vapor chamber 100.

For example, the accommodation cavity 140 is filled with a working medium. The working medium is also referred to as a cooling medium. For example, a material of the working medium includes at least one of deionized water, acetone, ethanol, and a fluorocarbon. When heat is transferred to the accommodation cavity 140 through the first cover 110 or the second cover 120, the working medium in the negative pressure state vaporizes after being heated. The vaporized working medium flows to a zone with a lower temperature, condenses and releases heat after being cooled, and returns under the capillary force of the capillary structure 130, to implement a heat transfer cycle. In an embodiment in which materials of the first metal layer 111 and the second metal layer 121 are both copper, because the deionized water, the ethanol, and the fluorocarbon do not chemically react with the copper, the copper has little impact on the foregoing heat cycle of the working medium.

A shape of the vapor chamber 100 is not limited in embodiments of this application. For example, the vapor chamber 100 may be in a square shape, a circular shape, an oval shape, or an irregular shape. It is clear that a shape of the first cover 110 and a shape of the second cover 120 are set based on the shape of the vapor chamber 100. The first cover 110 and the second cover 120 may alternatively be in a square shape, a circular shape, an oval shape, or an irregular shape. A shape of the first metal layer 111 is the same as that of the first cover 110. A shape of the second metal layer 121 is the same as the shape of the second cover 120. These are not limited in embodiments of this application.

Correspondingly, shapes of the first body part 101 and the second body part 201 are set based on a shape of the accommodation cavity 140. The first edge part 102 is disposed around the periphery of the first body part 101, and a shape of the first edge part 102 is set based on the shape of the first body part 101. Similarly, a shape of the second edge part 202 is set based on the shape of the second body part 201.

A thickness of the first cover 110 is not limited in embodiments of this application. The thickness of the first cover 110 is a size of the first cover 110 in the z direction. For example, the thickness of the first cover 110 ranges from 0.01 mm to 0.5 mm. For example, the thickness of the first cover 110 may be 0.01 mm, 0.05 mm, 0.1 mm, 0.15 mm, 0.2 mm, 0.25 mm, 0.3 mm, 0.35 mm, 0.4 mm, 0.45 mm, 0.5 mm, or the like.

A thickness of the second cover 120 is not limited in embodiments of this application either. For example, the thickness of the second cover 120 ranges from 0.01 mm to 0.5 mm. It may be understood that a ratio of the thickness of the first cover 110 to the thickness of the second cover 120 is not limited in embodiments of this application. In some embodiments, the thickness of the first cover 110 is equal to (1±0.2) times the thickness of the second cover 120. For example, the thickness of the first cover 110 is 0.8 times, 0.9 times, 0.95 times, 1 time, 1.05 times, 1.1 times, 1.15 times, 1.2 times, or the like the thickness of the second cover 120. Therefore, a difference between the thickness of the first cover 110 and the thickness of the second cover 120 is small, and a difference between stress of the first edge part 102 and stress of the second edge part 202 is small. In an application scenario in which the vapor chamber 100 is bent, bending has little impact on connection performance of the first edge part 102 and second edge part 202 that are connected, and a problem of delamination or tearing due to worse toughness between the first edge part 102 and the second edge part 202 is effectively alleviated.

It may be understood that, in another embodiment, the ratio of the thickness of the first cover 110 to the thickness of the second cover 120 may not fall within the foregoing range. For example, the thickness of the first cover 110 is 0.4 times, 1.5 times, 2 times, or the like the thickness of the second cover 120. This may be set based on an application scenario of the vapor chamber 100.

As described above, the first cover 110 includes the first metal layer 111, and the second cover 120 includes the second metal layer 121. It is clear that, in an embodiment in which the first cover 110 includes only the first metal layer 111, the thickness of the first cover 110 is a thickness of the first metal layer 111. Similarly, in an embodiment in which the second cover 120 includes only the second metal layer 121, the thickness of the second cover 120 is a thickness of the second metal layer 121. In embodiments of this application, the first cover 110 is not limited to the first metal layer 111. The second cover 120 is not limited to the second metal layer 121.

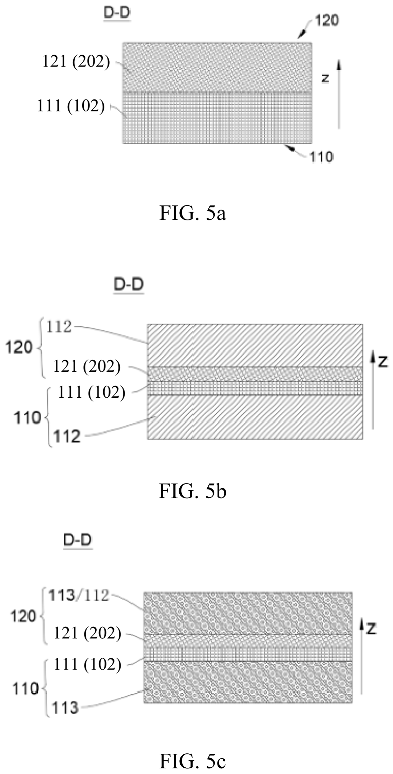

FIG. 5a is a cross-sectional view at D-D in FIG. 2a. In FIG. 5a, the first cover 110 includes only the first metal layer 111, and the second cover 120 includes only the second metal layer 121. In FIG. 5a, the thickness of the first metal layer 111 is the thickness of the first cover 110. The thickness of the second metal layer 121 is equal to the thickness of the second cover 120.

FIG. 5b is another cross-sectional view at D-D in FIG. 2a. In FIG. 5b, the first cover 110 further includes a support layer 112, and the support layer 112 is connected to a side that is of the first metal layer 111 and that is away from the second metal layer 121. The support layer 112 may be disposed to increase the thickness of the first cover 110. In addition, mechanical strength and a thickness of the support layer 112 may be set to adjust strength and the thickness of the first cover 110.

A material of the support layer 112 is not limited in embodiments of this application. For example, the material of the support layer 112 includes at least one of copper and an alloy thereof, titanium and an alloy thereof, aluminum and an alloy thereof, magnesium and an alloy thereof, and steel. Carbon content, iron content, and trace element content in the steel are not limited in embodiments of this application. Setting may be performed based on a type of steel. For example, the steel may be austenitic stainless steel like 201 steel, 304 steel, 316 steel, or 310 steel, or ferritic stainless steel like 430 steel or 446 steel. The following uses an example in which the material of the first metal layer 111 is copper for description. Therefore, there is a wide range of material options available for the support layer 112.

In some embodiments, the material of the support layer 112 includes steel whose nitrogen content is greater than 5%, and the steel whose nitrogen content is greater than 5% can increase the strength of the first cover 110, thereby helping increase strength of the vapor chamber. Therefore, the vapor chamber may be used to carry an electronic component in the electronic device, or the vapor chamber may be considered as a part of the middle frame.

In some embodiments, a quantity of crystal grains whose grain sizes are less than or equal to 50 µm at the support layer 112 having a length of at least 5 mm accounts for 70% of a total quantity of crystal grains. Similarly, a length of the support layer 112 is a size of the support layer 112 in a direction perpendicular to the z direction. Therefore, a material inside the support layer 112 is even, and internal stress of the support layer 112 is small. In some other embodiments, a size of a crystal grain at the support layer 112 may not be limited by the foregoing descriptions.

In some embodiments, the material of the support layer 112 is the same as the material of the first metal layer 111. In some other embodiments, the material of the support layer 112 may be different from the material of the first metal layer 111. For example, in some embodiments, the material of the first metal layer 111 is copper, and the material of the support layer 112 is stainless steel (for example, 304 steel or 316 steel). The copper layer isolates the accommodation cavity 140 from the stainless steel, to avoid a case that heat dissipation performance of the vapor chamber 100 deteriorates because a part of elements (for example, carbon, nickel, and nitrogen) in the stainless steel enter the accommodation cavity 140 and generate a non-condensable gas with the working medium. In addition, density of copper is 8.8 g/cm³, and density of stainless steel is 7.9 g/cm³. The stainless steel layer may reduce a weight of the first cover 110. In addition, stainless steel has high hardness, and can improve support performance of the first cover 110.

In embodiments of this application, the support layer 112 covers the entire side that is of the first metal layer 111 and that is away from the second metal layer 121. In other words, a vertical projection of the support layer 112 on a surface of the first metal layer 111 overlaps the surface of the first metal layer 111. In some other embodiments, the support layer 112 may cover only a part of the first metal layer 111.

A manner of connecting the support layer 112 to the first metal layer 111 is not limited in embodiments of this application. For example, the support layer 112 and the first metal layer 111 are formed through cold rolling.

In FIG. 5b, the second cover 120 may also include a support layer 112. In other words, the vapor chamber includes two support layers 112, one support layer 112 is located in the first cover 110, and the other support layer 112 is located in the second cover 120. The support layer 112 in the second cover 120 is connected to a side that is of the second metal layer 121 and that is away from the first metal layer 111. Parameters such as materials and thicknesses of the support layer 112 in the second cover 120 and the support layer 112 in the first cover 110 may be the same or may be different.

In an example in FIG. 5b, the thickness of the first metal layer 111 may be far less than the thickness of the first cover 110. For example, the thickness of the first metal layer 111 ranges from 5 µm to 80 µm. In some embodiments, the thickness of the first metal layer 111 may range from 5 µm to 10 µm. For example, the thickness of the first metal layer 111 may be 5 µm, 6 µm, 7 µm, 8 µm, 10 µm, 15 µm, 20 µm, 25 µm, 30 µm, 35 µm, 40 µm, 45 µm, 60 µm, 70 µm, 80 µm, or the like. Therefore, because sizes of 70% or more crystal grains in the first edge part 102 are less than or equal to 50 µm, even if the thickness of the first metal layer 111 is only 5 µm, connection performance of the joint between the first edge part 102 and the second edge part 202 is good, and the first metal layer 111 can well isolate a substance that generates a non-condensable gas from entering the accommodation cavity 140, so that the vapor chamber has good heat dissipation performance.

In some embodiments, to further reduce density of the vapor chamber, the vapor chamber may include a polymer material.

FIG. 5c is still another cross-sectional view at D-D in FIG. 2a. In FIG. 5c, the first cover 110 further includes a polymer layer 113, and the polymer layer 113 is connected to the side that is of the first metal layer 111 and that is away from the second metal layer 121. The polymer layer 113 and the first metal layer 111 are stacked in the z direction. The polymer layer 113 may reduce the weight of the first cover 110, thereby reducing a weight of the entire vapor chamber. This is conducive to lightweight of the vapor chamber and an electronic device including the vapor chamber.

In addition, uniform and small-sized crystal grains in the first edge part 102 can prevent the polymer layer 113 from passing through the first edge part 102 and affecting connection performance between the first edge part 102 and the second edge part 202. In addition, uniform and small-sized crystal grains in the first metal layer 111 can prevent the polymer layer 113 from entering the accommodation cavity 140, and prevent the polymer layer 113 from releasing a non-condensable gas in the accommodation cavity 140 to affect heat dissipation performance of the vapor chamber 100.

For example, a material of the polymer layer 113 includes polyimide (Polyimide, PI), polypropylene (Polypropylene, PP), polytetrafluoroethylene (Polytetrafluoroethylene, PTFE), polyethylene terephthalate (Polyethylene terephthalate, PET), polyethylene naphthalate (Polyethylene Naphthalate, PEN), polydimethylsiloxane (polydimethylsiloxane, PDMS), polyethylene (polyethylene, PE), poly propylene carbonate (Poly propylene carbonate, PPC), polyvinyl chloride (polyvinyl chloride, PVC), polyvinylidene chloride (Polyvinylidene chloride, PVdC), polystyrene (Polystyrene, PS), polyamide (Polyamide, PA), or the like.

In embodiments of this application, the polymer layer 113 covers the entire side that is of the first metal layer 111 and that is away from the second metal layer 121. In other words, a vertical projection of the polymer layer 113 on the surface of the first metal layer 111 overlaps the surface of the first metal layer 111.

In FIG. 5c, the second cover 120 may also include a polymer layer 113. Alternatively, the second cover 120 may include the support layer 112 described in the example in FIG. 5b.

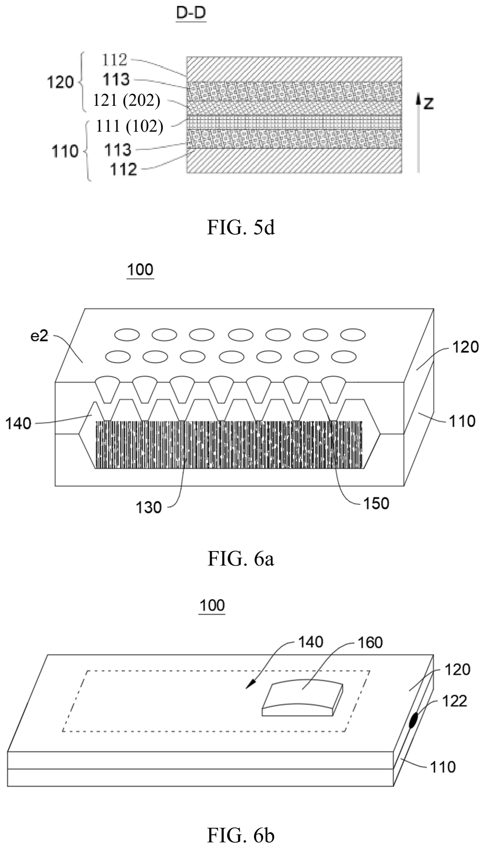

FIG. 5d is yet another cross-sectional view at D-D in FIG. 2a. In FIG. 5d, the first cover 110 includes the first metal layer 111, the polymer layer 113, and the support layer 112 that are sequentially stacked in the z direction. The support layer 112 may provide good support strength for the first cover 110, the polymer layer 113 may reduce the weight of the first cover 110, and the first metal layer 111 avoids deterioration of heat dissipation performance of the vapor chamber caused by formation of a non-condensable gas in the accommodation cavity 140. In addition, a connection between the first metal layer 111 and the second metal layer 121 further implements good connection performance of the joint between the first cover 110 and the second cover 120.

In FIG. 5d, the polymer layer 113 is located between the first metal layer 111 and the support layer 112. In another embodiment, the support layer 112 may be located between the polymer layer 113 and the first metal layer 111. In other words, the first metal layer 111, the support layer 112, and the polymer layer 113 are sequentially stacked in the z direction.

In FIG. 5d, the second cover 120 may also include the polymer layer 113 and the first metal layer 111. It may be understood that, in another embodiment, the second cover 120 may alternatively be of a structure shown in FIG. 5a, FIG. 5b, or FIG. 5c.

A quantity of support layers 112 and a quantity of polymer layers 113 in the first cover 110 are not limited in embodiments of this application. For example, there may be one, two, three, or more support layers 112, and there may be one, two, three, or more polymer layers 113. In an embodiment in which there are a plurality of support layers 112, parameters such as materials and sizes of the plurality of support layers 112 may be the same or different. In addition, in an embodiment in which there are a plurality of support layers 112 and a plurality of polymer layers 113, a manner of arranging the polymer layers 113 and the support layers 112 is not limited in embodiments of this application. For example, one support layer 112 may be disposed between two adjacent polymer layers 113, or two or three support layers 112 may be disposed between two adjacent polymer layers 113.

Still refer to FIG. 2b. The capillary structure 130 is located in the accommodation cavity 140 and is connected to the first body part 101.

A material of the capillary structure 130 is not limited in embodiments of this application. For example, the material of the capillary structure 130 includes at least one of aluminum and an alloy thereof, stainless steel, titanium and an alloy thereof, carbon fiber, graphene, graphite, copper and an alloy thereof, and a polymer material.

A manner of connecting the capillary structure 130 to the first body part 101 is not limited in embodiments of this application. In some embodiments, the capillary structure 130 is connected to the first body part 101 to form an integrated component. For example, the first body part 101 and the capillary structure 130 are formed on the first body part 101 through etching, laser processing, or the like. Therefore, a connection between the capillary structure 130 and the first body part 101 is good, and the capillary structure 130 and the first body part 101 are not prone to separation. In a scenario in which the vapor chamber 100 is bent, the first body part 101 and the capillary structure 130 that are integrally formed can effectively reduce friction caused by relative movement between the capillary structure 130 and the first body part 101 during bending of the vapor chamber 100. If the first body part 101 is bent, the capillary structure 130 and the first body part 101 are not prone to delamination and tearing.

In some other embodiments, the capillary structure 130 is connected to the first body part 101 through thermal processing. For example, in an embodiment in which the capillary structure 130 is a mesh structure, foamed metal, or metal powder, the capillary structure 130 is connected to the first body part 101 through sintering or thermal processing.

In some embodiments of this application, a distance between the capillary structure 130 and an inner edge of the first edge part 102 ranges from 1 mm to 3 mm. For example, the distance between the capillary structure 130 and the inner edge of the first edge part 102 is 1 mm, 2 mm, 3 mm, or the like. The inner edge of the first edge part 102 is an edge of a joint between the first edge part 102 and the first body part 101. Alternatively, the inner edge of the first edge part 102 is an edge that is of a zone in which the first edge part 102 is directly connected to the second edge part 202 and that is close to the accommodation cavity 140. The distance between the capillary structure 130 and the inner edge of the first edge part 102 is a distance between the capillary structure 130 and the inner edge of the first edge part 102 in a direction perpendicular to the z direction. Because the first edge part 102 is connected to the second edge part 202, it is clear that a distance between the capillary structure 130 and an inner edge of the second edge part 202 is the same as the distance between the capillary structure 130 and the inner edge of the first edge part 102. The distance between the capillary structure 130 and the inner edge of the first edge part 102 is within the foregoing range, and a process of connecting the first edge part 102 to the second edge part 202 has little impact on the capillary structure 130. This avoids impact of the connection process on a capillary force of a part of the capillary structure 130 close to a first edge part 102 zone.

In FIG. 2b, the vapor chamber 100 further includes a plurality of protrusions 150. The plurality of protrusions 150 are spaced from each other in the accommodation cavity 140. One end of each of the plurality of protrusions 150 is connected to the second body part 201, and the other end of each of the plurality of protrusions 150 is a free end. The plurality of protrusions 150 may increase a surface area in the accommodation cavity 140, and increase a contact area between the working medium and the accommodation cavity 140, so that the working medium is more easily attached to the accommodation cavity 140. Moreover, the protrusion 150 has a function of guiding the gaseous working medium. In addition, the protrusion 150 further has a flow-guiding function. The working medium attached to a surface of the protrusion 150 may flow along the surface of the protrusion 150 and converge. This helps shorten time of a heat cycle of the working medium and improve heat dissipation performance of the vapor chamber.

A position relationship between the protrusion 150 and the capillary structure 130 is not limited in embodiments of this application. In some embodiments, an end that is of the protrusion 150 and that is away from the second body part 201 is in contact with an end that is of the capillary structure 130 and that is away from the first body part 101. Therefore, after flowing to a free end of the protrusion 150, the working medium attached to the protrusion 150 enters the capillary structure 130 for circulation under an action of the capillary structure 130. In addition, the end of the protrusion 150 is in contact with the end of the capillary structure 130, so that a thickness of the vapor chamber can be reduced. It may be understood that, in another embodiment, there may be a gap between the end that is away from the second body part 201 and the end that is of the capillary structure 130 and that is away from the first body part 101.

A manner of arranging the plurality of protrusions 150 is not limited in embodiments of this application. In some embodiments, the plurality of protrusions 150 are arranged in order, for example, are distributed on the second body part 201 in a circular array or a rectangular array. In some other embodiments, the plurality of protrusions 150 may be arranged out of order. In addition, sizes of the protrusions 150 in the z direction may be the same or may be different. This is not limited in embodiments of this application.

In some embodiments, a material of the protrusion 150 is the same as the material of the second metal layer 121. The protrusion 150 does not chemically react with the working medium in the accommodation cavity 140 to generate a non-condensable gas, to avoid impact of the non-condensable gas on the heat dissipation performance of the vapor chamber.

A manner of connecting the protrusion 150 to the second body part 201 is not limited in embodiments of this application. For example, the protrusion 150 is connected to the second body part 201 to form an integrated component. For example, in FIG. 2b, the protrusion 150 and the second body part 201 are formed on the second body part 201 through etching or laser processing. Connection performance between the protrusion 150 and the second body part 201 is good. In addition, a process of forming the protrusion 150 through etching or laser processing has little impact on a shape of a surface that is of the second body part 201 and that is away from the protrusion 150. The surface that is of the second body part 201 and that is away from the protrusion 150 is flat. In FIG. 2b, a surface e1 that is of the second cover 120 and that is away from the protrusion 150 is a plane.

In some embodiments, a reinforcing rib may be disposed between the first cover 110 and the second cover 120. The reinforcing rib is located in the accommodation cavity 140. One end of the reinforcing rib is connected to the first cover 110, and the other end of the reinforcing rib is connected to the second cover 120. The reinforcing rib may increase structural strength of the vapor chamber 100, and improve support performance of the vapor chamber 100.

FIG. 6a is a diagram of an internal structure of another vapor chamber 100 according to an embodiment of this application. In FIG. 6a, a protrusion 150 and a second body part 201 are formed through stamping. During stamping molding, a surface that is of the second body part 201 and that is away from the protrusion 150 changes due to impact of stamping. For example, in FIG. 6a, there are a plurality of dents on the surface that is of the second body part 201 and that is away from the protrusion 150, and the surface is an uneven plane.

In an embodiment in which a second cover 120 includes a support layer 112, stamping is performed on both the support layer 112 and the second body part 201, so that the second body part 201 is formed on an inner wall of an accommodation cavity 140. In FIG. 6a, there are dents on a surface e2 that is of the second cover 120 and that is away from the protrusion 150.

It may be understood that, in some embodiments of this application, the protrusion 150 is not necessary, and the vapor chamber 100 may not be provided with the protrusion 150.

As described above, the vapor chamber 100 may be connected to the printed circuit board 13 of the electronic device 10. For example, the first cover 110 of the vapor chamber 100 is closer to the printed circuit board 13 than the second cover 120. For example, a surface that is of the first cover 110 and that is away from the second cover 120 is attached to the printed circuit board 13, and the second cover 120 is located on a side that is of the vapor chamber 100 and that is away from the printed circuit board 13. When the electronic device 10 operates, heat on the printed circuit board 13 is transferred to the accommodation cavity 140 through the first cover 110. A working medium in the accommodation cavity 140 vaporizes after absorbing the heat, the working medium in the accommodation cavity 140 releases heat and liquefies after reaching an inner surface of the second cover 120, and the working medium returns to an inner surface of the first cover 110 for a next heat cycle under actions of the protrusion 150 and the capillary structure 130.

In embodiments of this application, the first cover 110 and the printed circuit board 13 are not limited to being directly connected. For example, the first cover 110 and the printed circuit board 13 may be indirectly connected through another structure. For example, the first cover 110 is connected to the printed circuit board 13 through a thermally conductive adhesive layer. In some embodiments, a graphite layer may be further disposed between the first cover 110 and the printed circuit board 13.

As described above, in an embodiment in which the vapor chamber 100 and the printed circuit board 13 are located on two opposite sides of the middle frame 14, a part of the vapor chamber 100 penetrates the middle frame 14 and is connected to the printed circuit board 13, or a part of the printed circuit board 13 penetrates the middle frame 14 and is connected to the vapor chamber 100.

In some embodiments, the printed circuit board 13 has a high-heat zone. When the electronic device 10 operates, a temperature of the high-heat zone is higher than that of another zone on the printed circuit board 13, and a part of the vapor chamber 100 penetrates the middle frame 14 and is attached to the high-heat zone. Alternatively, the high-heat zone penetrates the middle frame 14 and is attached to the vapor chamber 100. After absorbing heat of the high-heat zone, a working medium in the vapor chamber 100 dissipates the heat for the high-heat zone.

For example, as shown in FIG. 1a, a through hole 17 is provided on the middle frame 14, and the through hole 17 penetrates the middle frame 14 in a thickness direction of the middle frame 14. The first cover 110 (as shown in FIG. 5) passes through the through hole 17 and is connected to the printed circuit board 13. For example, the first cover 110 passes through the through hole 17 and is connected to the high-heat zone of the printed circuit board 13. This helps reduce a total thickness of the middle frame 14 and the vapor chamber 100, increase integration of the electronic device 10, and facilitate miniaturization of the electronic device 10. In addition, the vapor chamber 100 may be considered as a part of the middle frame 14, and the vapor chamber 100 provides support strength for supporting structures such as the display 12, so that the vapor chamber 100 has a plurality of functions.

A shape of the through hole 17 is not limited in embodiments of this application. For example, the through hole 17 may be in a circular shape, a square shape, an oval shape, an irregular shape, or the like. A position of the through hole 17 may be set based on a position of the high-heat zone. This is not limited in embodiments of this application either.

In some embodiments, a size of the through hole 17 is large. For example, the size of the through hole 17 is similar to a size of the vapor chamber 100. The vapor chamber 100 is connected to the through hole 17, and the vapor chamber 100 may be considered as a part of the middle frame 14.

FIG. 1b is a diagram of structures of the middle frame 14 and the vapor chamber 100 according to an embodiment of this application. Refer to FIG. 1b. There is a stepped surface 171 on an inner wall of the through hole 17. The vapor chamber 100 is located in the through hole 17, and a periphery of the vapor chamber 100 is mounted on the stepped surface 171 and connected to the stepped surface 171. For example, the periphery of the vapor chamber 100 is bonded, soldered, or screwed to the stepped surface 171.

Therefore, the vapor chamber 100 may replace a part of the middle frame 14 and provide support performance. This can increase integration of the middle frame 14 and the vapor chamber 100, reduce volumes of the middle frame 14 and the vapor chamber 100, enable the vapor chamber 100 to have both heat dissipation and support functions, and reduce sizes of the middle frame 14 and the vapor chamber 100 in the z direction, for example, reduce a sum of thicknesses of the middle frame 14 and the vapor chamber 100 in the z direction by 0.1 mm or more, to increase the integration of the middle frame 14 and the vapor chamber 100.

FIG. 6b is a diagram of an internal structure of still another vapor chamber 100 according to an embodiment of this application. A difference between FIG. 6b and FIG. 2a lies in that a second cover 120 in FIG. 6b is provided with a convex part 160, and the convex part 160 is convexly disposed in a direction away from a first cover 110. In an embodiment in which a part of the vapor chamber 100 penetrates a middle frame 14 and is connected to a printed circuit board 13, the convex part 160 may penetrate the middle frame 14 and be connected to the printed circuit board 13. For example, the convex part 160 passes through the through hole 17 of the middle frame 14 shown in FIG. 1a and is connected to the printed circuit board 13.

It may be understood that the convex part 160 may be disposed on the first cover 110. Alternatively, both the first cover 110 and the second cover 120 may be provided with the convex part 160.

The vapor chamber 100 may be connected to another structure of the electronic device 10. A connection manner is similar to a connection manner of the printed circuit board 13. Details are not described herein again.

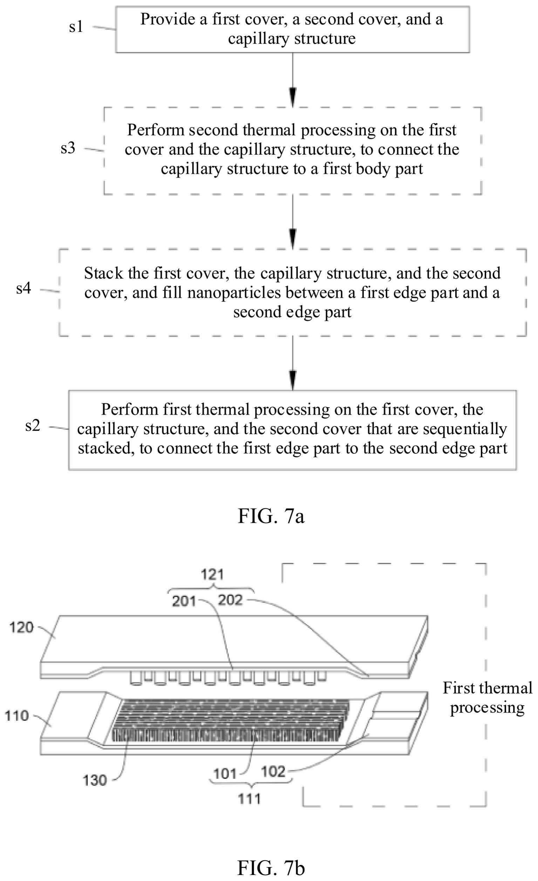

A process of the vapor chamber 100 is not limited in embodiments of this application. The following illustrates a partial manufacturing process of the vapor chamber 100 with reference to FIG. 7a.

FIG. 7a is a process flowchart of the vapor chamber 100 according to an embodiment of this application. Refer to FIG. 7a. A preparation process of the vapor chamber 100 includes the following steps.

s1: Provide the first cover 110, the second cover 120, and the capillary structure 130 shown in FIG. 2b.

For structures, materials, and the like of the first cover 110, the second cover 120, and the capillary structure 130, refer to the descriptions in FIG. 2b. Details are not described herein again.

s2: Perform first thermal processing on the first cover 110, the capillary structure 130, and the second cover 120 that are sequentially stacked, to connect the first edge part 102 to the second edge part 202, as shown in FIG. 7b.

A structure after s2 in FIG. 7a is performed is shown in FIG. 2b. The first edge part 102 is connected to the second edge part 202 to form the connection layer 20. For a structure of the connection layer 20, refer to the foregoing descriptions. Details are not described herein again.

In the first thermal processing in s2, a temperature ranges from 150°C to 400°C, pressure is greater than or equal to 30 MPa (megapascals), and time is greater than or equal to 30 min (minutes). In some embodiments, in the first thermal processing, the pressure ranges from 30 MPa to 200 MPa, and the time ranges from 30 min to 100 min. For example, the temperature in the first thermal processing may be 150°C, 170°C, 180°C, 190°C, 200°C, 210°C, 220°C, 240°C, 260°C, 270°C, 300°C, 310°C, 320°C, 330°C, 340°C, 350°C, 380°C, or 400°C. The pressure in the first thermal processing may be 30 MPa, 40 MPa, 50 MPa, 60 MPa, 70 MPa, 80 MPa, 90 MPa, 100 MPa, 110 MPa, 120 MPa, 140 MPa, 150 MPa, 160 MPa, 170 MPa, 180 MPa, 190 MPa, 200 MPa, 250 MPa, 350 MPa, 500 MPa, or the like. The time in the first thermal processing may be 30 min, 40 min, 50 min, 60 min, 70 min, 80 min, 90 min, 100 min, 130 min, 150 min, 180 min, 300 min, or the like.

For example, the first thermal processing on the first cover 110, the capillary structure 130, and the second cover 120 is performed in a container, for example, a sintering furnace.

For example, the first thermal processing on the first cover 110, the capillary structure 130, and the second cover 120 is performed in a protective atmosphere. A protective gas may be, for example, nitrogen or helium.

It may be understood that the temperature in the first thermal processing process is not limited to remain unchanged in embodiments of this application. For example, a temperature change in the first thermal processing process is within 15°C. Similarly, a pressure change amount in the first thermal processing process may be within 10 MPa.

In an example in FIG. 7a, the first edge part 102 may be connected to the second edge part 202 after the first thermal processing. In addition, after the connection, the first body part 101 and the second body part 201 jointly enclose the accommodation cavity 140. The temperature in the first thermal processing is low, so that a problem that the first cover 110 and the second cover 120 are deformed and oxidized at a high temperature is effectively alleviated.

In addition, because the temperature is low, the first thermal processing process has little impact on hardness and yield strength of the first cover 110 and the second cover 120. For example, after the first cover 110 is connected to the second cover 120, a decrease degree of the hardness of the first cover 110 is less than or equal to 20%, and a decrease degree of the yield strength of the first cover 110 is less than or equal to 20%. Similarly, after the first cover 110 is connected to the second cover 120, a decrease degree of the hardness of the second cover 120 is less than or equal to 20%, and a decrease degree of the yield strength of the second cover 120 is less than or equal to 20%.

In addition, high pressure in the first thermal processing process causes atoms between the first edge part 102 and the second edge part 202 to be diffused and mixed, to form the connection layer 20 with a large binding force. In addition, sizes of 70% or more of the crystal grains at the connection layer 20 are less than 50 µm. The crystal grains at the connection layer 20 are even and small, and internal stress of the connection layer 20 is low, so that the connection layer 20 is not prone to delamination or cracking.

Further, in an embodiment in which the material of the support layer 112 is stainless steel, the temperature in the first thermal processing is low, a diffusion distance of a trace element (for example, aluminum) in the stainless steel is small, and a quantity of non-condensable gases generated when the trace element enters the accommodation cavity 140 is small, so that the heat dissipation performance of the vapor chamber is improved.

In an embodiment in which the first cover 110 includes the polymer layer 113 (as shown in FIG. 5d), the temperature in the first thermal processing is low, so that a problem like cracking, blackening, or delamination of a polymer material of the polymer layer 113 caused by a high temperature is effectively alleviated. An embodiment in which the second cover 120 includes a polymer layer is similar.

In addition, even if the thickness of the first metal layer 111 is small, for example, 5 µm, because the temperature in the first thermal processing is low, the first thermal processing has little impact on physical properties such as hardness of the thin first metal layer 111.

In addition, because the temperature in the first thermal processing is low, the micro-nano structure (for example, a barb or a pore) on the surface of the capillary structure 130 is not prone to collapse or melting in the first thermal processing process, and the better capillary force of the capillary structure 130 can also improve the heat dissipation performance of the vapor chamber.

In some embodiments, if there is dust or impurities on surfaces of the first cover 110 and the second cover 120 that are provided, the first cover 110 and the second cover 120 may be first cleaned to remove the impurities or the dust, and then s1 in FIG. 7a is performed.

For example, in an embodiment in which the surface of the first cover 110 or the surface of the second cover 120 includes an oxide layer like copper oxide, the oxide layer on the surface of the first cover 110 or the oxide layer on the surface of the second cover 120 may be first removed before S1 in FIG. 7a is performed.

It may be understood that, in some embodiments, after s2 in FIG. 7a is performed, the process may further include: injecting a working medium into the accommodation cavity 140, vacuumizing the accommodation cavity 140 to make the accommodation cavity 140 in a vacuum negative pressure state, and sealing the opening 122 of the accommodation cavity 140 (as shown in FIG. 2b).

In an embodiment in which the vapor chamber 100 includes the protrusion 150, the protrusion 150 may be disposed on the provided first cover 110. A manner of disposing the protrusion 150 includes but is not limited to stamping, laser processing, or etching.

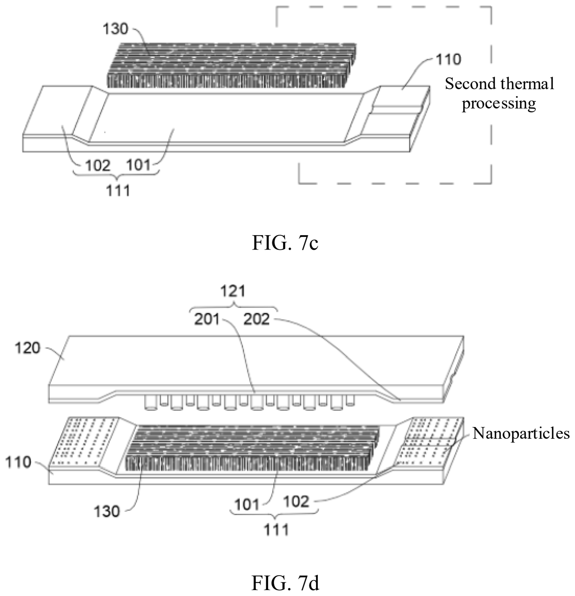

In this embodiment, the provided capillary structure 130 may be connected to the first body part 101 of the first cover 110. In some embodiments, the provided capillary structure 130 may not be connected to the first body part 101 of the first cover 110, and s3 in FIG. 7a may be performed to connect the capillary structure 130 to the first body part 101 of the first cover 110. In other words, s3 in FIG. 7a is an optional process. If the provided capillary structure 130 is not connected to the first cover 110, after s1 and before s2, the process further includes the following step:
s3: Perform second thermal processing on the first cover 110 and the capillary structure 130, to connect the capillary structure 130 to the first body part 101, as shown in FIG. 7c.

For example, in an embodiment in which the capillary structure 130 is a mesh structure, foamed metal, or metal powder, the capillary structure 130 is connected to the first body part 101 after s3 is performed. Structures of the first cover 110 and the capillary structure 130 after s3 is performed are shown in FIG. 7b.

In the second thermal processing, a temperature ranges from 150°C to 400°C, pressure is greater than or equal to 5 MPa, and time is greater than or equal to 30 min. In some embodiments, in the second thermal processing, the pressure ranges from 5 MPa to 200 MPa, and the time ranges from 30 min to 100 min. For example, the temperature in the second thermal processing may be 150°C, 170°C, 180°C, 190°C, 200°C, 210°C, 220°C, 240°C, 260°C, 270°C, 300°C, 310°C, 320°C, 330°C, 340°C, 350°C, 380°C, or 400°C. The pressure in the second thermal processing may be 5 MPa, 10 MPa, 20 MPa, 30 MPa, 40 MPa, 50 MPa, 70 MPa, 80 MPa, 100 MPa, 110 MPa, 120 MPa, 150 MPa, 160 MPa, 170 MPa, 180 MPa, 200 MPa, 250 MPa, 350 MPa, 500 MPa, or the like. The time in the second thermal processing may be 30 min, 40 min, 50 min, 60 min, 70 min, 80 min, 90 min, 100 min, 130 min, 150 min, 180 min, 280 min, or the like.

For example, the second thermal processing on the first cover 110 and the second cover 120 is performed in a container, for example, a sintering furnace. The temperature in the second thermal processing process is not limited to remain unchanged in embodiments of this application. For example, a temperature change in the first thermal processing process is within 15°C. Similarly, a pressure change amount in the second thermal processing process may be within 10 MPa.

For example, the second thermal processing on the first cover 110 and the capillary structure 130 is performed in a protective atmosphere. A protective gas may be, for example, nitrogen or helium.

Same as that in the first thermal processing, the temperature in the second thermal processing is low, the second thermal processing process has little impact on the capillary structure 130 and the first cover 110, so that the first cover 110 can maintain good hardness and yield strength after the second thermal processing. In the second thermal processing process, the first cover 110 has a small grain growth size, and an element on a side that is of the first cover 110 and that is away from the capillary structure 130 is not likely to diffuse to a side close to the capillary structure 130. In the second thermal processing process of the capillary structure 130, the micro-nano structure on the capillary structure 130 is not prone to collapse or deformation, and a good capillary force can still be kept, so that the heat dissipation performance of the vapor chamber is good.

In some embodiments of this application, before s2 is performed, nanoparticles may be disposed between the first edge part 102 and the second edge part 202, to promote atoms between the surface of the first edge part 102 and the surface of the second edge part 202 to be diffused, so that crystal grains at the joint between the first edge part 102 and the second edge part 202 grow rapidly, and the first edge part 102 is connected to the second edge part 202 in a short time.

In some embodiments, to make crystal grains on the surfaces of the first edge part 102 and the second edge part 202 be rapidly fused, optionally, before s2, the process further includes the following step:
s4: Stack the first cover 110, the capillary structure 130, and the second cover 120, and fill nanoparticles between the first edge part 102 and the second edge part 202, as shown in FIG. 7d.

The nanoparticles help rapidly fuse the crystal grains on the surfaces of the first edge part 102 and the second edge part 202 in the first processing process. The nanoparticle functions as a crystal grain nucleus, to help shorten time of nucleation on the surfaces of the first edge part 102 and the second edge part 202, and shorten formation time of the connection layer.

Filling the nanoparticles between the first edge part 102 and the second edge part 202 may be, for example, placing the nanoparticles on a surface that is of the first edge part 102 and that faces the second edge part 202, or placing the nanoparticles on a surface that is of the second edge part 202 and that faces the first edge part 102.

A material of the nanoparticle is not limited in embodiments of this application. For example, the material of the nanoparticle may include at least one of titanium and an alloy thereof, aluminum and an alloy thereof, copper and an alloy thereof, carbon, or magnesium and an alloy thereof. In the first thermal processing process, the nanoparticle may serve as a nucleus of the crystal grain to promote growth of the crystal grain, to shorten time for connecting the first edge part 102 to the second edge part 202.

For example, a particle size of the nanoparticle is less than or equal to 10 µm. In some embodiments, the particle size of the nanoparticle may range from 50 nm to 5 µm. For example, the particle size of the nanoparticle may be 50 nm, 100 nm, 200 nm, 400 nm, 500 nm, 700 nm, 800 nm, 1 µm, 2 µm, 3 µm, 4 µm, 5 µm, or the like.

It may be understood that the preparation process of the vapor chamber 100 provided in this embodiment of this application is not limited to the process shown in FIG. 7a. Another process may be used.

The vapor chamber in this embodiment of this application may include a metal cover and a connection layer, is mainly formed by metal crystal grains with small grain sizes, and may feature high strength and high stiffness macroscopically; or may include a part of non-metal materials, features high flexibility, and satisfies heat dissipation requirements of different electronic products.

In the descriptions of this specification, specific features, structures, materials, or characteristics may be combined in a proper manner in any one or more of embodiments or examples. Finally, it should be noted that the foregoing embodiments are merely intended for describing the technical solutions of this application, but not for limiting this application. Although this application is described in detail with reference to the foregoing embodiments, persons of ordinary skill in the art should understand that they may still make modifications to the technical solutions described in the foregoing embodiments or make equivalent replacements to a part of technical features thereof, without departing from the spirit and scope of the technical solutions of embodiments of this application.

## Claims

1. A vapor chamber, wherein the vapor chamber comprises:
a first cover, comprising a first metal layer, wherein the first metal layer comprises a first body part and a first edge part disposed around a periphery of the first body part;
a second cover, comprising a second metal layer, wherein the second metal layer comprises a second body part and a second edge part disposed around a periphery of the second body part, a surface of the first edge part is connected to a surface of the second edge part to form a connection layer, and the first body part and the second body part jointly enclose an accommodation cavity; and
a capillary structure, located in the accommodation cavity and connected to the first body part, wherein
in a direction perpendicular to a thickness direction of the connection layer, a quantity of crystal grains whose grain sizes are less than or equal to 50 µm at the connection layer having a length of at least 5 mm accounts for 70% or more of a total quantity of crystal grains.

2. The vapor chamber according to claim 1, wherein the quantity of crystal grains whose grain sizes are less than or equal to 50 µm at the connection layer accounts for 70% or more of the total quantity of crystal grains.

3. The vapor chamber according to claim 1 or 2, wherein a material of the first metal layer is a first metal material, the first edge part has a first surface and a second surface that are disposed opposite to each other, the second surface is connected to the surface of the second edge part, and a mass percentage of the first metal material is greater than or equal to 95% at a location that is in the first edge part and that is at a distance greater than or equal to 3 µm from the first surface.

4. The vapor chamber according to any one of claims 1 to 3, wherein the first cover further comprises a support layer, and the support layer is connected to a side that is of the first metal layer and that is away from the second metal layer.

5. The vapor chamber according to claim 4, wherein a material of the support layer comprises at least one of titanium and an alloy thereof, aluminum and an alloy thereof, magnesium and an alloy thereof, and steel.

6. The vapor chamber according to any one of claims 1 to 5, wherein the first cover further comprises a polymer layer, and the polymer layer is connected to the side that is of the first metal layer and that is away from the second metal layer.

7. The vapor chamber according to any one of claims 1 to 6, wherein the material of the first metal layer comprises at least one of copper and an alloy thereof, or aluminum and an alloy thereof.

8. The vapor chamber according to any one of claims 1 to 7, wherein a thickness of the first metal layer ranges from 5 µm to 80 µm.

9. The vapor chamber according to any one of claims 1 to 8, wherein the vapor chamber further comprises a plurality of protrusions that are spaced from each other in the accommodation cavity, and one end of each of the plurality of protrusions is connected to the second body part, and the other end is a free end.

10. The vapor chamber according to any one of claims 1 to 9, wherein the capillary structure is connected to the first body part to form an integrated component.

11. A method for preparing a vapor chamber, wherein the method for preparing the vapor chamber comprises:
providing a first cover, a second cover, and a capillary structure, wherein the first cover comprises a first metal layer, and the first metal layer comprises a first body part and a first edge part disposed around a periphery of the first body part; the second cover comprises a second metal layer, and the second metal layer comprises a second body part and a second edge part disposed around a periphery of the second body part; and the capillary structure is connected to the first body part; and
performing first thermal processing on the first cover, the capillary structure, and the second cover that are sequentially stacked, to connect the first edge part to the second edge part, wherein
in the first thermal processing, a temperature ranges from 150°C to 400°C, pressure is greater than or equal to 30 MPa, and time is greater than or equal to 30 min to 100 min.

12. The method for preparing the vapor chamber according to claim 11, wherein before a step of performing the first thermal processing on the first cover, the capillary structure, and the second cover that are sequentially stacked, the method further comprises:
performing second thermal processing on the first cover and the capillary structure, to connect the capillary structure to the first body part, wherein
in the second thermal processing, a temperature ranges from 150°C to 400°C, pressure is greater than or equal to 5 MPa, and time is greater than or equal to 30 min.

13. The method for preparing the vapor chamber according to claim 11 or 12, wherein before the step of performing the first thermal processing on the first cover, the capillary structure, and the second cover that are sequentially stacked, the method further comprises:
stacking the first cover, the capillary structure, and the second cover, and filling nanoparticles between the first edge part and the second edge part.

14. An electronic device, wherein the electronic device comprises a printed circuit board and the vapor chamber according to any one of claims 1 to 10, and the first cover is connected to the printed circuit board.

15. The electronic device according to claim 14, wherein the electronic device further comprises a middle frame; the vapor chamber, the middle frame, and the printed circuit board are sequentially stacked; and a through hole that penetrates the middle frame in a thickness direction of the middle frame is disposed on the middle frame, and the first cover passes through the through hole and is connected to the printed circuit board.
